# EUROPEAN PATENT SPECIFICATION

(11) **EP 0 347 479 B1**
(45) Date of publication and mention of the grant of the patent: **13.04.1994**
(21) Application number: 88109922.0
(22) Date of filing: 22.06.1988
(51) Int. Cl.: H01L 29/06

(54) **Semiconductor device having improved withstanding voltage characteristics**
Halbleiteranordnung mit hoher Durchbruchsspannungscharakteristik
Dispositif semi-conducteur caractérisé par sa haute tension de laquage

(43) Date of publication of application: 27.12.1989
(73) Proprietor: KABUSHIKI KAISHA TOSHIBA, Kawasaki-shi, Kanagawa-ken 210 (JP)
(72) Inventor: Shirai, Koji c/o Patent Division, Minato-ku Tokyo 105 (JP); Kawamura, Ken c/o Patent Division, Minato-ku Tokyo 105 (JP)
(74) Representative: Lehn, Werner, Dipl.-Ing.

(56) References cited:
- EP-A- 0 061 551
- PATENT ABSTRACTS OF JAPAN, vol. 7, no. 129 (E-179)[1274], 4th June 1983 ; & JP-A-58 46 678 (OKI DENKI KOGYO K.K.) 18-03-1983
- PATENT ABSTRACTS OF JAPAN, vol. 7, no. 94 (E-171)[1239], 20th April 1983 ; & JP-A-58 17 676 (TOKYO SHIBAURA DENKI K.K.) 01-02-1983

## Description

The present invention relates to a semiconductor device having improved withstanding voltage characteristics.

In a conventional semiconductor device such as a semiconductor integrated circuit (IC), a conductive layer called a field plate is frequently formed so as to improve the withstanding voltage characteristics between a substrate and a diffusion region formed therein.

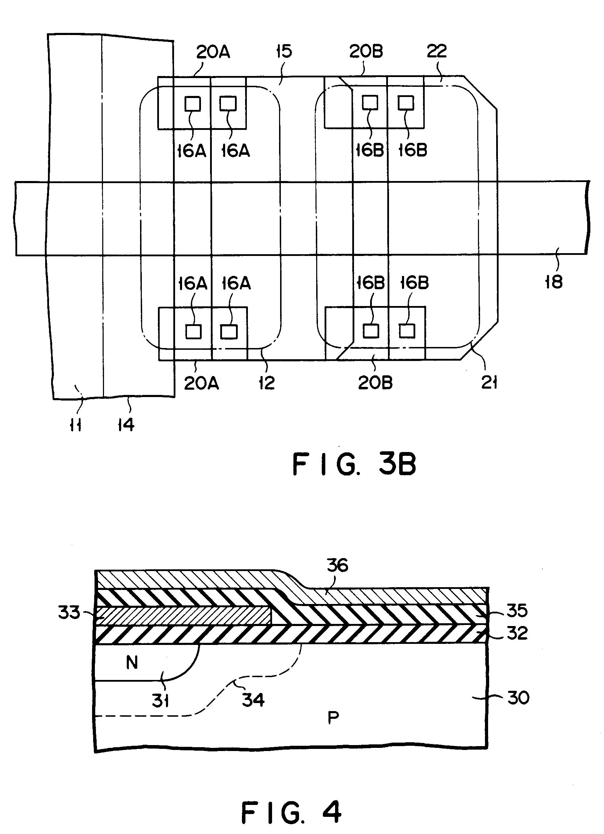

Fig. 4 is a sectional view of a semiconductor device having the field plate described above. N-type diffusion region 31 is formed in p-type silicon semiconductor substrate 30. Field plate 33 consisting of polysilicon or the like is formed through insulating layer 32 on a substrate surface near the end of diffusion region 31. The potential of field plate 33 is set at the same value as that of diffusion region 31. When field plate 33 is formed, depletion layer 34 extending from diffusion region 31 in the substrate is spread near the end of field plate 33, thereby improving the withstanding voltage characteristics between substrate 30 and diffusion region 31.

In a conventional IC, however, other wiring layer 36 is often formed through insulating layer 35 on field plate 33, as shown in Fig. 4. In this case, an electric field is concentrated near the end of field plate 33 by the influence of a difference between the potentials of wiring layer 36 and field plate 33. Therefore, the withstanding voltage between substrate 30 and diffusion region 31 is considerably decreased as compared with a case wherein wiring layer 36 is not arranged.

The thicknesses of insulating layers 32 and 35 may be increased as a countermeasure against the above problem. However, the process and pattern are limited in this method. For example, a wiring step coverage tends to be poor at corners having a thin insulating film. In addition, variations in thickness undesirably cause large variations in withstanding voltage characteristics.

When the thickness of the insulating layer is increased, cracks occur in the insulating layer and hence wiring layer 36 formed thereon. Therefore, this method has a disadvantage in reliability.

As has been described above, in a semiconductor device having a field plate, variations in withstanding voltage characteristics occur, thereby degrading reliability of the device.

EP-A-0 061 551 describes a planar type semiconductor device with a high break-down voltage having a diffusion region of P type formed in a semiconductor layer of N type, at least one guard ring region of P type provided surrounding the diffusion region and an insulating film covering a given portion on a surface of the semiconductor layer of N type. The planar type semiconductor device is further comprised of a first field plate kept at the potential equal to that of the diffusion region and a second field plate which is provided on the insulating film outside a guard ring-region and is kept at the potential equal to that of the guard ring region.

The present invention has been made in consideration of the above situation, and has as its object to provide a semiconductor device which can increase a withstanding voltage without variations in withstanding voltage characteristics and degradation of reliability.

A semiconductor device according to the present invention comprises: a first semiconductor region of a first conductivity type; a second semiconductor region of a second conductivity type formed in said first semiconductor region; a first insulating layer formed on a surface of said first semiconductor region, including a surface of said second semiconductor region; a first conductive layer formed, via said first insulating layer, over the surface of said second semiconductor region, and set at substantially the same potential as that of said second semiconductor region; a third semiconductor region of the second semiconductivity type formed in said first semiconductor region so as to be spaced apart from said second semiconductor region and to underlie a part of said first conductive layer, via said insulating layer, and a second conductive layer electrically connected to said third semiconductor region through an opening formed in said first insulating layer, and a conductive wiring layer formed, via a second insulating layer, over surfaces of said first and second conductive layers.

According to the semiconductor device of the present invention, second semiconductor region 12 is formed, such that it partially overlaps, via first insulating layer 13, and first field plate layer 14. Therefore, the potential of second semiconductor region 12 is lower than that of first field plate 14 by a value corresponding to the thickness of first insulating layer 13. In addition, second field plate 15 is formed through first insulating layer 13 on a surface of second semiconductor region 12. Therefore, an electric field between second semiconductor and semiconductor substrate regions 12 and 10 is reduced.

This invention can be more fully understood from the following detailed description when taken in conjunction with the accompanying drawings, in which:
Figs. 1A and 1B show an arrangement according to a first embodiment of the present invention, in which Fig. 1A is a sectional view of the arrangement, and Fig. 1B is a plan view showing a pattern of the arrangement;
Figs. 2A and 2B show an arrangement according to a second embodiment of the present invention, in which Fig. 2A is a sectional view of the arrangement, and Fig. 2B is a plan view showing a pattern of the arrangement;
Figs. 3A and 3B show an arrangement according to a third embodiment of the present invention, in which Fig. 3A is a sectional view of the arrangement, and
Fig. 3B is a plan view showing a pattern of the arrangement; and
Fig. 4 is a sectional view of a device having the problems to be solved by the present invention.

Preferred embodiments of the present invention will be described below with reference to the accompanying drawings.

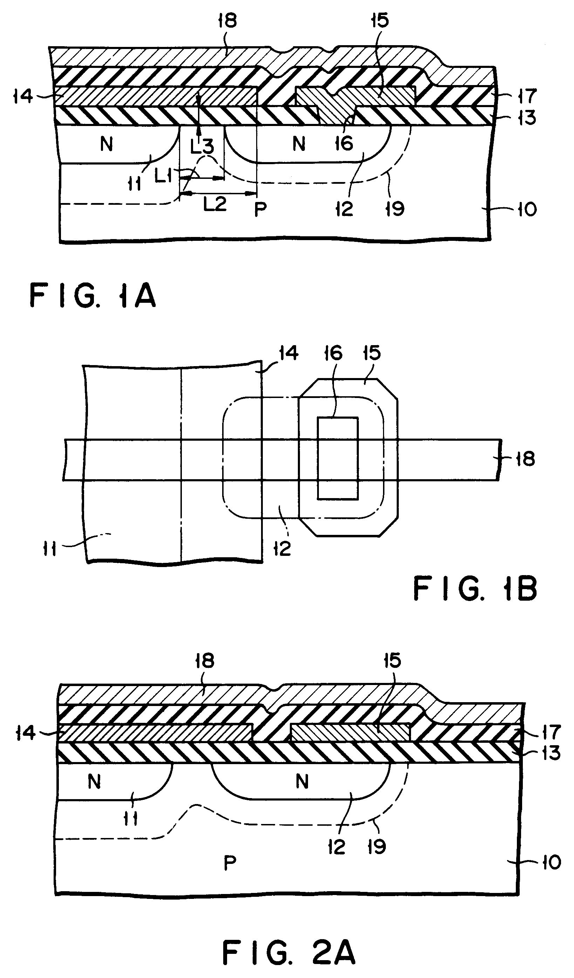

Figs. 1A and 1B show an arrangement according to a first embodiment of the present invention, in which Fig. 1A is a sectional view and Fig. 1B is a plan view showing a pattern of the arrangement.

Referring to Figs. 1A and 1B, n-type diffusion regions 11 and 12 are separately formed in p-type silicon semiconductor substrate 10. Silicon oxide (SiO₂) insulating layer 13, having a predetermined thickness, is formed on a surface of substrate 10, including the surfaces of diffusion regions 11 and 12.

In addition, polysilicon field plate 14 is formed, via insulating layer 13, over a substrate surface near the end of diffusion region 11. Field plate 14 is formed so as to partially overlap diffusion region 12. Polysilicon field plate 15 is formed through insulating layer 13 on a substrate surface near the end of diffusion region 12. Field plate 15 is connected to a surface of diffusion region 12 formed thereunder, through opening 16 formed in insulating layer 13. Silicon oxide insulating layer 17 is formed on field plates 14 and 15. Wiring layer 18 consisting of aluminum or the like is formed on insulating layer 17.

Note that opening 16 for connecting field plate 15 to diffusion region 12 is formed below wiring layer 18, as is shown by a plan view of the pattern in Fig. 1B.

Assume that substrate 10 is set at a reference potential (0 V), that diffusion region 11 is set at a high potential of about +100 V, and that wiring layer 18 is set at 0 V, respectively. Also assume that field plate 14 is electrically connected to diffusion region 11 in a region which is not shown, and the potential of field plate 14 is set at substantially the same potential as that of diffusion region 11, i.e., about +100 V. Although not shown, a connection structure between region 11 and plate 14 may be the same as that between region 12 and plate 15.

In the above potential state, a spread state of a depletion layer in substrate 10 is represented by reference numeral 19 in Fig. 1A.

More specifically, field plate 14 is formed so as to partially overlap diffusion region 12 which is spaced apart from diffusion region 11. For this reason, the potential of diffusion region 12 depends on a distance between regions 11 and 12 and is lower than the potential of field plate 14 by a value corresponding to the thickness of insulating layer 13. The potential of diffusion region 12 is, for example, half the potential of field plate 14, i.e., about +50 V. The potential is substantially constant throughout diffusion region 12. Therefore, the potential of field plate 15 connected to diffusion region 12 is about +50 V. When wiring layer 18 is set at 0 V, the electric field intensity between the end of field plate 15 and wiring layer 18 is reduced to a half that in the device not having field plate 15 and diffusion region 12. For this reason, the withstanding voltage between diffusion region 12 and substrate 10 is greatly increased.

Assume that, in Fig. 1A, distance L1 between ends of N regions 11 and 12 is 15 µm, that distance L2 between ends of N region 11 and field plate 14 is 20 µm, that thickness L3 of insulating layer 13 is 1 µm, and that a concentration of a p-type impurity such as boron is 5 × 10¹⁴ cm⁻³. Under these conditions, when wiring layer 18 is not formed, a breakdown voltage of the p-n junction between N region 11 and P substrate 10 is about 400 V at room temperature.

When wiring layer 18 having a potential of 0 V is formed without N region 12 under the same conditions as described above, however, the breakdown voltage of the p-n junction between N region 11 and P substrate 10 is reduced to about 200 V to 250 V. As is shown in Fig. 1A, when region 12 according to the present invention is formed, the breakdown voltage of the p-n junction between N region 11 and P substrate 10 can be increased to about 300 V to 350 V, in spite of the presence of wiring layer 18 having a potential of 0 V.

As has been described above, in the first embodiment, the withstanding voltage characteristics can be improved without increasing the thickness of interlayer insulating layer 13. As a result, disadvantages of the conventional device caused upon increasing the thickness of the interlayer insulating layer, such as variations in withstanding voltage characteristics or degradation of reliability, are completely eliminated.

In addition, when the withstanding voltage can be increased, if the withstanding voltage characteristics remain substantially the same as those of the conventional device, a higher potential than the potential of the conventional device can be applied to diffusion region 11. Therefore, the device according to the present invention is effectively used for various applications.

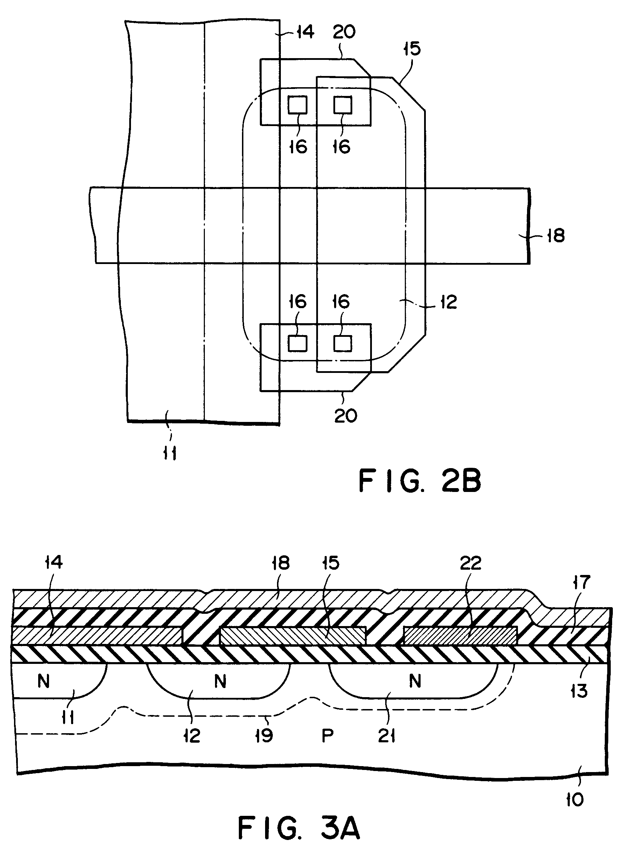

Figs. 2A and 2B show an arrangement according to a second embodiment of the present invention, in which Fig. 2A is a sectional view, and Fig. 2B is a plan view showing a pattern of the arrangement. A difference between the devices of the first and second embodiments is as follows. In the second embodiment, a plurality of openings 16 for connecting field plate 15 and diffusion region 12 are formed in the region except for portions under wiring layer 18, as shown in the plan view in Fig. 12B. Each aluminum wiring layer 20 is formed at a pair of corresponding openings 16. Diffusion region 12 is connected to field plate 15 through wiring layers 20.

In the structure shown in Figs. 1A and 1B, a step of forming opening 16 in insulating layer 13 is required besides the opening forming step of connecting aluminum wiring layer 18 to a prescribed circuit element on substrate 10. On the contrary, in Figs. 2A and 2B, N layer 12 can be electrically connected to field plate 15 in the step of forming openings 16 in aluminum layers 20. This step can be simultaneously performed together with the step of forming an opening in aluminum wiring layer 18. Therefore, the embodiment in Figs. 2A and 2B is more advantageous than the embodiment in Figs. 1A and 1B because the number of device manufacturing steps is reduced.

On the other hand, aluminum wiring layer 18 overlaps opening 16, in the structure shown in Figs. 1A and 1B. In the structure in Fig. 2, openings 16 are separately formed next to aluminum wiring layer 18. Therefore, the structure in Figs. 1A and 1B is more advantageous than the structure in Fig. 2 because a packing density of the device is increased.

Figs. 3A and 3B show an arrangement according to a third embodiment of the present invention, in which Fig. 3A is a sectional view, and Fig. 3B is a plan view showing a pattern of the arrangement. In the device of the third embodiment, diffusion region 12, serving as a diffusion region other than diffusion region 11 to which a high voltage is directly applied, is formed in the same manner as the above devices according to the first and second embodiments. At the same time, n-type diffusion region 21 spaced apart from above diffusion regions 11 and 12 is formed. Field plate 15 is formed so as to partially overlap diffusion region 21. Polysilicon field plate 22 is formed through insulating layer 13 on a surface near the end of diffusion region 21.

Field plate 15 is connected to diffusion region 12 through openings 16A formed in the region except for the region under wiring layer 18, via aluminum wiring layers 20A, in the same manner as in Figs. 2A and 2B. Field plate 22 is connected to diffusion region 21 through openings 16B formed in the region except for the region under wiring layer 18, via aluminum wiring layers 20B, in the same manner as field plate 15 described above.

In the device according to the third embodiment, field plate 15 is formed so as to partially overlap diffusion region 21 which is spaced apart from diffusion region 12. For this reason, the potential of diffusion region 21 is lower, by a value corresponding to the thickness of insulating layer 13, than the potential of diffusion region 12 whose potential is further reduced from the potential of diffusion region 11. The potential of diffusion region 21 is, for example, half the potential of field plate 15, i.e., about +25 V. Therefore, the potential of field plate 22 connected to diffusion region 21 is reduced to about +25 V. An electric field intensity between the end of field plate 22 and wiring layer 18 is further reduced below that in Figs. 1 and 2. For this reason, the withstanding voltage characteristics between substrate 10 and diffusion region 21 are further improved.

It is a matter of course that the present invention is not limited to the above embodiments, and various modifications can be effected. In the above embodiments, for example, diffusion region 12 or two series diffusion regions 12 and 21 are formed as the regions other than diffusion region 11. However, the number of diffusion regions arranged in series through the field plate can be desirably increased to three or more, thereby further improving the withstanding voltage characteristics.

In addition, in the above embodiments, the n-type diffusion region is formed in the p-type substrate, however, p-type well region 10 can be similarly formed in the n-type substrate.

In addition, structures (12, 15, etc.) for improving withstanding voltage characteristics according to the present invention can be applied to not only an Si semiconductor but also a GaAs semiconductor.

Materials for field plates 14, 15, and 22 are not limited to polysilicon. A refractory metal such as Mo or Ti, or a silicide of a refractory metal such as W, Mo, or Ti can be used for the field plate.

As has been described above, according to the present invention, there is provided a semiconductor device which can increase its withstanding voltage without variations in withstanding voltage characteristics and degradation of reliability of the device.

## Claims

1. A semiconductor device comprising:
a first semiconductor region (10) of a first conductivity type (P);
a second semiconductor region (11) of a second conductivity type (N) formed in said first semiconductor region (10);
a first insulating layer (13) formed on a surface of said first semiconductor region (10), inclucing a surface of said second semiconductor region (11);
a first conductive layer (14) formed, via said first insulating layer (13), over the surface of said second semiconductor region (11), and set at substantially the same potential as that of said second semiconductor region (11);
a third semiconductor region (12) of the second semiconductivity type (N) formed in said first semiconductor region (10) so as to be spaced apart from said second semiconductor region (11) and to underlie a part of said first conductive layer (14), via said insulating layer (13),
and a second conductive layer (15) electrically connected to said third semiconductor region (12) through an opening (16) formed in said first insulting layer (13);
**characterized** by
a conductive wiring layer (18) formed, via a second insulating layer (17), over surfaces of said first and second conductive layers (14) and (15).

2. A device according to claim 1
**characterized** in that
said opening (16) is formed under said conductive wiring layer (18).

3. A device according to claim 1,
**characterized** in that
said opening (16) is formed on a portion except for a portion under said conductive wiring layer (18).

4. A device according to claim 1
**characterized** in that
said first semiconductor region (10) is a substrate region (10); said second semiconductor region (11) is exposed on a surface of said substrate region (10); said third semiconductor region (12) is exposed on the surface of said substrate region (10) and arranged adjacent to said second semiconductor region (11); said first conductive layer (14) is a first field plate (14) and is formed over a portion defined by a first distance (L2) which includes a second distance (L1) between adjacent ends of said second and third semiconductor regions (11 and 12), and a third distance of overlap of a part of said first field plate (14) over the third semiconductor region (12) via the first insulating layer (13), said first field plate (14) receiving a potential which is substantially the same as a potential of said second semiconductor region (11); said second conductive layer (15) is a second field plate (15) formed via said first insulating layer (13) over said third semiconductor region (12), excluding the portion defined by said first distance (L2); said opening (16) comprises a connector means (16) for applying substantially the same potential as the potential of said third semiconductor region (12) to said second field plate (15); and that said conductive wiring layer (18) receivies a potential which is different from the potentials of said first and second field plates (14, 15).

5. A device according to claim 4,
**characterized** in that
a portion of said second field plate (15) is in contact with said third semiconductor region(12) through said opening (16).

6. A device according to claim 4,
**characterized** in that
said opening (16) is formed in part of said first insulating layer (13) immediately under said wiring layer (18) over said third semiconductor region (12); and
a portion of said second field plate (15) is in contact with said third semiconductor region (12) through said opening (16).

7. A device according to claim 4,
**characterized** in that
said opening (16) is formed in part of said first insulating layer (13) on said third semiconductor region (12), excluding the part immediately under said wiring layer (18); and
a portion of said second field plate (15) is in contact with said third semiconductor region (12) through said opening (16).

8. A device according to claim 4,
**characterized** in that
said first and second field plates (14, 15) include polysilicon.

9. A device according to claim 4,
**characterized** in that
said first and second field plates (14, 15) include Mo or Ti.

10. A device according to claim 4,
**characterized** in that
said first and second field plates (14, 15) include a silicide of W, Mo or Ti.

11. A device according to claim 4, further including:
a fourth semiconductor region (21) of the second conductivity type (N) formed in said semiconductor substrate region (10), exposed on the surface of said semiconductor substrate region (10), and spaced apart from said second and third semiconductor regions (11, 12) to be adjacent to said third semiconductor region (12);
a third field plate (22), having a conductive property, and formed via said first insulating layer (13) over said fourth semiconductor region (21), excluding a portion formed between the ends of said third and fourth semiconductor regions;
second connecting means (16B) for applying substantially the same potential as the potential of said fourth semiconductor region (21) to said third field plate (22),
wherein said second field plate (15) is formed through said first insulating layer (13) on said third semiconductor region (12), including the portion between the ends of said third and fourth semiconductor regions (12, 21).

## Patentansprüche

1. Halbleitereinrichtung, aufweisend:
einen ersten Halbleiterbereich (10) eines ersten Leitungstyps (P);
einen zweiten Halbleiterbereich (11) eines zweiten Leitungstyps (N), der auf dem ersten Halbleiterbereich (10) gebildet ist;
eine erste Isolierschicht (13), die auf einer Oberfläche des ersten Halbleiterbereichs (10) gebildet ist und eine Oberfläche des zweiten Halbleiterbereichs (11) einschließt;
eine erste leitende Schicht (14), die über die erste Isolierschicht (13) oberhalb der Oberfläche des zweiten Halbleiterbereichs (11) gebildet und auf das im wesentlichen gleiche Potential wie das des zweiten Halbleiterbereichs (11) gesetzt ist;
einen dritten Halbleiterbereich (12) des zweiten Leitungstyps (N), der auf dem ersten Halbleiterbereich (10) gebildet ist, derart, daß er Abstand zum zweiten Halbleiterbereich (11) hält und über die Isolierschicht (13) unterhalb eines Teils der ersten leitenden Schicht (14) liegt; und
eine zweite leitende Schicht (15), die elektrisch durch eine Öffnung (16) in der ersten Isolierschicht (13) elektrisch an den dritten Halbleiterbereich (12) angeschlossen ist,
**gekennzeichnet** durch eine leitende Verdrahtungsschicht (18), die über eine zweite Isolierschicht (17) oberhalb von über Oberflächen der ersten und zweiten leitenden Schichten (14 und 15) gebildet ist.

2. Einrichtung nach Anspruch 1, dadurch gekennzeichnet, daß die Öffnung (16) unter der leitenden Verdrahtungsschicht (18) gebildet ist.

3. Einrichtung nach Anspruch 1, dadurch gekennzeichnet, daß die Öffnung (16) auf einem Abschnitt gebildet ist, mit Ausnahme eines unter der leitenden Verdrahtungsschicht (18) verlaufenden Abschnittes.

4. Einrichtung nach Anspruch 1, dadurch gekennzeichnet, daß
der erste Halbleiterbereich (10) ein Substratbereich (10) ist; der zweite Halbleiterbereich (11) auf einer Oberfläche des Substratbereiches (10) aufgebracht ist; der dritte Halbleiterbereich (12) auf der Oberfläche des Substratbereichs (10) aufgebracht und neben dem zweiten Halbleiterbereich (11) angeordnet ist; die erste leitende Schicht (14) eine erste Feldplatte (14) ist und über einem Abschnitt gebildet ist, welcher durch einen ersten Abstand (L2) definiert ist, der einen zweiten Abstand (L1) zwischen benachbarten Enden des zweiten und des dritten Halbleiterbereichs (11 und 12) und einen dritten Überlappungsabstand enthält, der über die erste Isolierschicht (13) einen Teil der ersten Feldplatte (14) über dem dritten Halbleiterbereich (12) überdeckt, wobei die erste Feldplatte (14) ein Potential empfängt, das im wesentlichen das gleiche wie ein Potential des zweiten Halbleiterbereichs (11) ist; die zweite leitende Schicht (15) eine zweite Feldplatte (15) ist, die über die erste Isolierschicht (13) über dem dritten Halbleiterbereich (12) gebildet ist, unter Ausschluß des durch den ersten Abstand (L2) defnierten Abschnittes;
wobei die Öffnung (16) ein Anschlußmittel (16) zum Anlegen im wesentlichen des gleichen Potentials wie das Potential des dritten Halbleiterbereichs (12) an die zweite Feldplatte (15) aufweist; und daß die leitende Verdrahtungsschicht (18) ein Potential empfängt, das sich von den Potentialen der ersten und der zweiten Feldplatte (14, 15) unterscheidet.

5. Einrichtung nach Anspruch 4, dadurch gekennzeichnet, daß ein Abschnitt der zweiten Feldplatte (15) durch die Öffnung (16) mit dem dritten Halbleiterbereich (12) in Kontakt steht.

6. Einrichtung nach Anspruch 4, dadurch gekennzeichnet, daß die Öffnung (16) in einem Teil der ersten Isolierschicht (13) unmittelbar unter der Verdrahtungsschicht (18) über dem dritten Halbleiterbereich (12) liegt, gebildet ist; und
ein Abschnitt der zweiten Feldplatte (15) durch die Öffnung (16) in Kontakt mit dem dritten Halbleiterbereich (12) steht.

7. Einrichtung nach Anspruch 4, dadurch gekennzeichnet, daß die Öffnung (16) in einem Teil der ersten Isolierschicht (13) auf dem dritten Halbleiterbereich (12) gebildet ist, unter Ausschluß des Teils unmittelbar unter der Verdrahtungsschicht (18); und
ein Abschnitt der zweiten Feldplatte (15) durch die Öffnung (16) in Kontakt mit dem dritten Halbleiterbereich (12) steht.

8. Einrichtung nach Anspruch 4, dadurch gekennzeichnet, daß die erste und die zweite Feldplatte (14, 15) Polysilizium aufweisen.

9. Einrichtung nach Anspruch 4, dadurch gekennzeichnet, daß die erste und zweite Feldplatte (14, 15) aus Mo oder Ti aufweisen.

10. Einrichtung nach Anspruch 4, dadurch gekennzeichnet, daß die erste und die zweite Feldplatte (14, 15) ein Silicid von W, Mo oder Ti aufweisen.

11. Einrichtung nach Anspruch 4, die weiter aufweist:
einen vierten Halbleiterbereich (21) eines zweiten Leitungstyps (N), der im Halbleitersubstratbereich (10) auf der Oberfläche des Halbleitersubstratbereichs (10) gebildet ist und zum zweiten und dritten Halbleiterbereich (11, 12) Abstand hält, um dem dritten Halbleiterbereich (12) benachbart zu sein;
eine dritte Feldplatte (22), die leitfähig ist und, über die erste Isolierschicht (13) auf dem vierten Halbleiterbereich (21) gebildet ist, mit Ausnahme eines Abschnittes, der zwischen den Enden des dritten und es vierten Halbleiterbereichs gebildet ist;
zweite Anschlußmittel (16B) zum Anlegen des im wesentlichen gleichen Potentials wie das Potential des vierten Halbleiterbereichs (21) an die dritte Feldplatte (22);
wobei die zweite Feldplatte (15) durch die erste Isolierschicht (13) auf dem dritten Halbleiterbereich (12) gebildet ist, einschließlich des Abschnittes zwischen den Enden des dritten und des vierten Halbleiterbereichs (12, 21).

## Revendications

1. Dispositif à semiconducteur, comprenant :
- une première région de semiconducteur (10) d'un premier type de conductivité (P);
- une deuxième région de semiconducteur (11) d'un deuxième type de conductivité (N) formée dans ladite première région de semiconducteur (10);
- une première couche isolante (13) formée sur une surface de ladite première région de semiconducteur (10), incluant une surface de ladite deuxième région de semiconducteur (11);
- une première couche conductrice (14) formée, avec séparation par ladite première couche isolante (13), sur la surface de ladite deuxième région de semiconducteur (11) et mise sensiblement au même potentiel que celui de ladite deuxième région de semiconducteur (11);
- une troisième région de semiconducteur (12) du deuxième type de conductivité (N) formée dans ladite première région de semiconducteur (10) de manière à être espacée de ladite deuxième région de semiconducteur (11) et à être située au-dessous d'une partie de ladite première couche conductrice (14), avec séparation par ladite couche isolante (13); et
- une deuxième couche conductrice (15) connectée électriquement à ladite troisième région de semiconducteur (12) à travers une ouverture (16) formée dans ladite première couche isolante (13);
caractérisé par :
- une couche conductrice de câblage (18) formée, avec interposition d'une deuxième couche isolante (17), sur les surfaces desdites première et deuxième couches conductrices (14) et (15).

2. Dispositif selon la revendication 1, caractérisé en ce que ladite ouverture (16) est formée sous ladite couche conductrice de câblage (18).

3. Dispositif selon la revendication 1, caractérisé en ce que ladite ouverture (16) est formée sur une partie sauf une partie sous ladite couche conductrice de câblage (18).

4. Dispositif selon la revendication 1, caractérisé en ce que ladite première région de semiconducteur (10) est une région de substrat (10); ladite deuxième région de semiconducteur (11) est exposée sur une surface de ladite région de substrat 10; ladite troisième région de semiconducteur (12) est exposée sur la surface de ladite région de substrat (10) et disposée adjacente à ladite deuxième région de semiconducteur (11); ladite première couche conductrice (14) est une première plaque de champ (14) et est formée sur une partie définie par une première distance (L2) qui inclut une deuxième distance (L1) entre des extrémités adjacentes desdites deuxième et troisième régions de semiconducteur (11 et 12), et une troisième distance de chevauchement d'une partie de ladite première plaque de champ (14) sur la troisième région de semiconducteur (12), avec séparation par la première couche isolante (13), ladite première plaque de champ (14) recevant un potentiel qui est sensiblement le même qu'un potentiel de ladite deuxième région de semiconducteur (11); ladite deuxième couche conductrice (15) est une deuxième plaque de champ (15) formée, avec séparation par la première couche isolante (13), sur ladite troisième région de semiconducteur (12), sauf la partie définie par ladite première distance (L2); ladite ouverture (16) comprend des moyens formant connecteur (16) pour appliquer sensiblement le même potentiel que le patentiel de ladite troisième région de semiconducteur (12) à ladite deuxième plaque de champ (15); et en ce que ladite couche conductrice de câblage (18) reçoit un potentiel qui est différent des potentiels desdites première et deuxième plaques de champ (14, 15).

5. Dispositif selon la revendication 4, caractérisé en ce qu'une partie de ladite deuxième plaque de champ (15) est en contact avec ladite troisième région de semiconducteur (12) à travers ladite ouverture (16).

6. Dispositif selon la revendication 4, caractérisé en ce que ladite ouverture (16) est formée en partie de ladite couche isolante (13) immédiatement sous ladite couche de câblage (18) sur ladite troisième région de semiconducteur (12); et une partie de ladite deuxième plaque de champ (15) étant en contact avec ladite troisième région de semiconducteur (12) à travers ladite ouverture (16).

7. Dispositif selon la revendication 4, caractérisé en ce que :
- ladite ouverture (16) est formée en partie de ladite première couche isolante (13) sur ladite troisième région de semiconducteur, sauf la partie immédiatement sous ladite couche de câblage (18); et
- une partie de ladite deuxième plaque de champ (15) est en contact avec ladite troisième région de semiconducteur (12) à travers ladite ouverture (16).

8. Dispositif selon la revendication 4, caractérisé en ce que lesdites première et deuxième plaques de champ (14, 15) comprennent du polysilicium.

9. Dispositif selon la revendication 4, caractérisé en ce que lesdites première et deuxième plaques de champ (14, 15) comprennent du Mo ou du Ti.

10. Dispositif selon la revendication 4, caractérisé en ce que lesdites première et deuxième plaques de champ (14, 15) comprennent du siliciure de W, Mo ou Ti.

11. Dispositif selon la revendication 4, comprenant en outre une quatrième région de semiconducteur (21) du deuxième type de conductivité (N) formée dans ladite région de substrat de semiconducteur (10), exposée sur la surface de ladite région de substrat de semiconducteur (10) et espacée desdites deuxième et troisième régions de semiconducteur (11, 12) pour être adjacente à ladite troisième région de semiconducteur (12);
- une troisième plaque de champ (22) ayant une propriété de conduction et formée, avec séparation par ladite première couche isolante (13), sur ladite quatrième région de semiconducteur (21), sauf une partie formée entre les extrémités desdites troisième et quatrième régions de semiconducteur;
- des deuxièmes moyens de connexion (16B) pour appliquer sensiblement le même potentiel que le potentiel de ladite quatrième région de semiconducteur (21) à ladite troisième plaque de champ (22);
dans lequel ladite deuxième plaque de champ (15) est formée, avec séparation par ladite première couche isolante (13), sur ladite troisième région de semiconducteur (12), y compris la partie entre les extrémités desdites troisième et quatrième régions de semiconducteur (12, 21).
